# EUROPÄISCHE PATENTSCHRIFT

(11) **EP 3 981 229 B1**
(45) Veröffentlichungstag und Bekanntmachung des Hinweises auf die Patenterteilung: **05.04.2023**
(21) Anmeldenummer: 20726849.1
(22) Anmeldetag: 22.05.2020
(51) Int. Cl.: H05K 7/20, H05K 5/04, H05K 9/00

(54) **VERFAHREN ZUR HERSTELLUNG EINES EIN STEUERGERÄT UMSCHLIESSENDEN GEHÄUSES**
METHOD FOR PRODUCING A HOUSING ENCLOSING A CONTROL UNIT
PROCÉDÉ DE FABRICATION D'UN BOÎTIER COMPRENANT UNE UNITÉ DE COMMANDE

(30) Priorität: 07.06.2019 EP 19179010
(43) Veröffentlichungstag der Anmeldung: 13.04.2022
(73) Patentinhaber: ZKW Group GmbH, 3250 Wieselburg (AT)
(72) Erfinder: KOLLER, Jan, 1120 Wien (AT); GRAF, Harald, Würflach 2732 (AT)
(74) Vertreter: Patentanwaltskanzlei Matschnig & Forsthuber OG
(86) Internationale Anmeldenummer: PCT/EP2020/064287
(87) Internationale Veröffentlichungsnummer: WO 2020/244935

(56) Entgegenhaltungen:
- EP-A1- 0 770 817
- DE-A1-102010 041 831
- US-A1- 2004 240 192
- US-B2- 6 535 387

## Beschreibung

Die Erfindung betrifft ein Verfahren zur Herstellung eines ein Steuergerät umschließenden Gehäuses durch mechanisches Formen eines Ausgangsmaterials, wobei das Steuergerät insbesondere zum Steuern eines Kraftfahrzeugscheinwerfers eingerichtet ist.

Die Erfindung betrifft ferner ein Steuerungsmodul.

Die Erfindung betrifft überdies einen Kraftfahrzeugscheinwerfer.

Im Stand der Technik werden Steuergeräte für Kraftfahrzeugscheinwerfer meist durch ein Gehäuse umschlossen. Zum Abführen der im Steuergerät entstehenden Wärme werden die bekannten Gehäuse in der Regel mit Kühlvorrichtungen, beispielsweise Kühlrippen, an einer Gehäuseaußenseite ausgestattet. Dazu müssen die Kühlrippen mit dem Gehäuse verbunden werden, wobei dazu wärmeleitende Klebstoffe eingesetzt werden, welche eine gewisse Aushärtezeit aufweisen. Bisherige Unternehmungen zur Optimierung gekühlter Gehäuse für Steuergeräte betrafen Verbesserungen bei der Materialauswahl für das Gehäuse und die Kühlrippen, Variationen bei der Gehäusegröße in Relation zur Kühlrippengröße oder die Verwendung von schnellhärtenden Klebstoffen.

Die DE 10 2010 041831 A1 zeigt eine elektronische Steuereinrichtung für eine Beleuchtungseinrichtung eines Kraftfahrzeugs. Aus der EP 0 770 817 A1 ist ein Scheinwerfer für Fahrzeuge mit einem Scheinwerfergehäuse bekannt. Das Dokument US 2004/240192 A1 offenbart eine einstückige Abschirmvorrichtung für elektromagnetische Strahlung. Das Dokument US 6 535 387 B2 offenbart eine Vorrichtung zum Verteilen und Abführen von Wärmeenergie von wärmeerzeugenden Komponenten.

Die Aufgabe der vorliegenden Erfindung besteht darin, eine Möglichkeit zu schaffen, mit der die Nachteile des Standes der Technik überwunden werden.

Diese Aufgabe wird durch das erfindungsgemäße Verfahren gelöst, welches die folgenden Verfahrensschritte umfasst:
a) Bereitstellen eines im Wesentlichen streifenförmigen, vorzugsweise metallischen, Ausgangsmaterials, welches eine Oberseite und eine Unterseite aufweist, wobei das Ausgangsmaterial in zumindest drei aneinander angrenzende Teilbereiche unterteilt ist, welche durch Faltachsen getrennt sind;
b) Formen von Kühlrippen an einem ersten Teilbereich des Ausgangsmaterials (nach Schritt a);
c) Formen eines Gehäusebodens an einem zweiten Teilbereich des Ausgangsmaterials, welcher vorzugsweise einem Mittelbereich des Ausgangsmaterials entspricht, wobei das Ausgangsmaterial zwischen dem ersten Teilbereich und dem zweiten Teilbereich eine erste Faltachse aufweist (nach Schritt a);
d) Formen eines Gehäusedeckels an einem dritten Teilbereich des Ausgangsmaterials, wobei das Ausgangsmaterial zwischen dem zweiten Teilbereich und dem dritten Teilbereich eine zweite Faltachse aufweist (nach Schritt a);
e) Ausführen eines Faltvorgangs, bei welchem die Unterseite des ersten Teilbereichs des Ausgangsmaterials um die erste Faltachse auf die Unterseite des zweiten Teilbereichs des Ausgangsmaterials gefaltet wird, sodass im gefalteten Zustand der erste Teilbereich und der zweite Teilbereich im Wesentlichen deckungsgleich übereinander orientiert sind, wobei die Unterseite des ersten Teilbereichs und die Unterseite des zweiten Teilbereichs direkt, vorzugsweise zumindest abschnittweise vollflächig, miteinander in Kontakt sind (nach Schritten b und c);
f) Anbringen von dem Steuergerät, welches insbesondere dazu eingerichtet ist einen Kraftfahrzeugscheinwerfer zu steuern, an der Oberseite des zweiten Teilbereichs des Ausgangsmaterials (nach Schritt c);
g) Ausführen eines Faltvorgangs, bei welchem die Oberseite des dritten Teilbereichs des Ausgangsmaterials um die zweite Faltachse auf die Oberseite des zweiten Teilbereichs des Ausgangsmaterials gefaltet wird, oder Ausführen eines Faltvorgangs, bei welchem die Unterseite des dritten Teilbereichs des Ausgangsmaterials um die zweite Faltachse auf die Oberseite des zweiten Teilbereichs des Ausgangsmaterials gefaltet wird, sodass im gefalteten Zustand der zweite Teilbereich und der dritte Teilbereich im Wesentlichen deckungsgleich übereinander orientiert sind, wobei der in Schritt c) geformte Gehäuseboden und der in Schritt d) geformte Gehäusedeckel derart ausgebildet sind, dass im übereinander gefalteten Zustand zwischen dem Gehäuseboden und dem Gehäusedeckel eine das Steuergerät umschließende Gehäusekammer gebildet ist (nach Schritt f);
h) Fixieren des ersten Teilbereichs an dem zweiten Teilbereich und/oder Fixieren des zweiten Teilbereichs an dem dritten Teilbereich mit zumindest einem Fixiermittel, sodass der erste Teilbereich mit dem zweiten Teilbereich und/oder der zweite Teilbereich mit dem dritten Teilbereich durch das Zusammenwirken des Fixiermittels miteinander verbunden sind (nach Schritten e und g).

Die zeitliche Abfolge der im Anspruch 1 angegebenen Verfahrensschritte ist, sofern nicht anders angegeben, frei wählbar. Beispielsweise kann die zeitliche Abfolge der Schritte b, c, d auch b, d, c oder c, b, d oder c, d, b oder d, b, c oder d, c, b sein. Als Ausgangsmaterial ist beispielsweise Stahl, Edelstahl oder Aluminium vorgesehen. Ein Fachmann wählt das Ausgangsmaterial dahingehend aus, dass das Ausgangsmaterial plastisches Formen und plastisches Falten bruchfrei zulässt. Das Ausgangsmaterials ist bevorzugt streifenförmig, wobei das Ausgangsmaterial beispielsweise eine Länge von 25 cm bis 75 cm, eine Breite von 6 cm bis 20 cm und eine Dicke von 0,3 mm bis 2 mm aufweist. An den Faltachsen kann das Ausgangsmaterial eine im Vergleich zu dem ersten, zweiten und dritten Teilbereich verringerte Dicke aufweisen, um die Faltvorgänge zu erleichtern. Das Formen der Kühlrippen an dem ersten Teilbereich des Ausgangsmaterials umfasst insbesondere das mechanische Formen beispielsweise das Pressen des ersten Teilbereichs gegen eine entsprechende Kontur. Das Formen des Gehäusebodens bzw. des Gehäusedeckels an dem zweiten bzw. dem dritten Teilbereich des Ausgangsmaterial umfasst insbesondere das Formen von zumindest einer Ausnehmung an dem zweiten und/oder dritten Teilbereich, wobei die Ausnehmung eine Form haben kann, welche eine räumliche Ausdehnung aufweist, welche zumindest gleich oder größer als die räumliche Ausdehnung des Steuergeräts ist. Die Faltvorgänge gemäß den Schritten e) und g) umfassen ein mechanisches Falten des Ausgangsmaterials, wobei vorzugsweise ein Faltwerkzeug an der entsprechenden Faltachse angelegt und anschließend der Faltvorgang durchgeführt wird. Dabei wird das Ausgangsmaterial plastisch verformt. Nach dem Faltvorgang gemäß Schritt e) sind die Kühlrippen vorzugsweise zumindest abschnittsweise in direktem Kontakt mit dem Gehäuseboden, um eine effiziente Kühlung des Gehäusebodens zu erreichen. Nach dem Formen der Kühlrippen, des Gehäusebodens und des Gehäusedeckels, weisen der erste, zweite und dritte Teilbereich des Ausgangsmaterials vorzugsweise die gleiche Länge und/oder Breite auf. Das Steuergerät kann auch dazu eingerichtet sein, einen Kraftfahrzeugmotor, ein Kraftfahrzeuggetriebe, das Fahrwerk eines Kraftfahrzeugs oder Hydraulikvorrichtungen, beispielsweise für Baumaschinen oder landwirtschaftliche Maschinen, zu steuern.

Vorzugsweise grenzen der erste Teilbereich an den zweiten Teilbereich und der zweite Teilbereich an den dritten Teilbereich an, sodass der zweite Teilbereich zwischen dem ersten und dem dritten Teilbereich angeordnet ist oder es grenzen der zweite Teilbereich an den ersten Teilbereich und der erste Teilbereich an den dritten Teilbereich an, sodass der erste Teilbereich zwischen dem zweiten und dem dritten Teilberiech angeordnet ist. Insbesondere grenzt im ungefalteten Zustand der erste Teilbereich nicht an den dritten Teilbereich, oder der zweite Teilbereich nicht an den dritten Teilbereich an.

Das zumindest eine Fixiermittel kann als zumindest eine Faltlasche, Nietenverbindung, Schweißverbindung, Rastverbindung oder Klebeverbindung ausgebildet sein. Zumindest eine Bohrung für die Nietverbindung kann vor oder nach den Faltvorgängen in das Ausgangsmaterial eingebracht werden. Die zumindest eine Faltlasche kann beispielsweise an einem Randbereich des ersten und/oder zweiten und/oder dritten Teilbereichs geformt werden. Nach dem ersten und/oder zweiten Faltvorgang, kann die zumindest eine Lasche gefaltet werden, sodass die zumindest eine Lasche, welche an einem Randberiech eines Teilbereichs geformt ist, nachdem sie gefaltet wurde, einen anderen Teilbereich zumindest teilweise umschließt. Alternativ dazu kann auch eine Rastverbindung vorgesehen sein, wobei zumindest eine Rastnase an einem Teilbereich des Ausgangsmaterials geformt wird, und eine entsprechende Ausnehmung, in welche die Rastnase einrasten kann, an einen anderen Teilbereich geformt wird. Wird ein Teilbereich auf einen anderen Teilbereich gemäß den Schritten e) und g) gefaltet, kann die Rastnase in die entsprechende Ausnehmung einrasten.

Das zumindest eine Fixiermittel kann insbesondere ein erstes und ein zweites Fixiermittel umfassen, wobei das erste Fixiermittel den ersten Teilbereich an dem zweiten Teilbereich fixiert und das zweite Fixiermittel den zweiten Teilbereich an dem dritten Teilbereich fixiert. Das erste und das zweite Fixiermittel können gleichartig oder unterschiedlich sein. Ein Fixiermittel kann auch den ersten Teilbereich an dem dritten Teilbereich fixieren, sodass der zweite Teilbereich, welcher im gefalteten Zustand des Ausgangsmaterials in einer vertikalen Richtung zwischen dem ersten und dem dritten Teilbereich angeordnet ist, sandwichartig von dem ersten und dem dritten Teilbereich fixiert wird.

Vorzugsweise ist das zweite Fixiermittel als Klebeverbindung ausgebildet, die den Gehäuseboden an dem Gehäusedeckel fixiert und dazu eingerichtet ist, die Gehäusekammer abzudichten. Damit kann vorteilhafterweise der Gehäusedeckel an dem Gehäuseboden fixiert werden und gleichzeitig wird das Gehäuse abgedichtet und somit gegen etwaige Verschmutzung geschützt. Die Klebeverbindung ist bevorzugt eine Kleberschicht, welche beispielsweise entlang eines Randbereichs des zweiten und/oder dritten Teilbereichs des Ausgangsmaterials vor dem Faltvorgang als geschlossene Klebstoffbahn aufgetragen wird.

Insbesondere kann das Verfahren (zeitlich) nach Schritt c) und vor dem Anbringen des Steuergeräts gemäß Schritt f) den folgenden weiteren Schritt umfassen:
- Anbringen eines Füllmaterials zwischen dem Steuergerät und dem zweiten Teilbereich, wobei das Füllmaterial eine Wärmeleitpaste, insbesondere eine silikonhaltige oder silikonfreie pastöse Wärmeleitpaste, umfasst.

Durch das Füllmaterial kann vorteilhafterweise die Abfuhr von Wärme, welche von dem Steuergerät erzeugt wird, begünstigt werden. Durch das Füllmaterial kann insbesondere auch der Kontakt und die Haftung des Steuergeräts an dem zweiten Teilbereich verbessert werden.

Vorzugsweise umfasst das Steuergerät eine Leiterplatte mit einer daran angebrachten elektronischen Schaltung zum Ansteuern des Kraftfahrzeugscheinwerfers, wobei das Füllmaterial insbesondere zwischen der Leiterplatte und dem zweiten Teilbereich angebracht wird.

Um eine besonders effiziente Wärmeabfuhr von dem Steuergerät zu den Kühlrippen zu ermöglichen, ist es günstig wenn das Füllmaterial eine Wärmeleitfähigkeit größer 1 W/mK, bevorzugt größer 5 W/mK, besonders bevorzugt größer 10 W/mK aufweist.

Vorzugsweise umfasst das Ausgangsmaterial einen Metallstreifen, wobei das Metall mechanische Eigenschaften aufweist, welche plastische und bruchfrei Faltvorgänge gemäß den Verfahrensschritten e) und g) zulassen.

Besonders bevorzugt besteht das Ausgangmaterial aus einem einzigen Metallstreifen. Dadurch ist vorteilhafterweise das Gehäuse des Steuergeräts im Wesentlichen einstückig ausgebildet. Mit anderen Worten werden die Kühlvorrichtung, der Gehäuseboden und der Gehäusedeckel, welche im Wesentlichen das Gehäuse bilden, aus einem einzigen Metallstreifen geformt. Dadurch kann der Herstellungsprozess günstiger und schneller durchgeführt werden.

Erfindungsgemäß ist ein Steuerungsmodul vorgesehen, umfassend ein Steuergerät, welches insbesondere zur Steuerung eines Kraftfahrzeugscheinwerfers eingerichtet ist, und ein Gehäuse, wobei das Gehäuse nach dem erfindungsgemäßen Verfahren hergestellt ist. Das Steuergerät kann auch dazu eingerichtet sein, einen Kraftfahrzeugmotor, ein Kraftfahrzeuggetriebe, das Fahrwerk eines Kraftfahrzeugs oder Hydraulikvorrichtungen, beispielsweise für Baumaschinen oder landwirtschaftliche Maschinen, zu steuern.

Erfindungsgemäß ist ein Kraftfahrzeugscheinwerfer vorgesehen, umfassend das erfindungsgemäße Steuerungsmodul.

Im Rahmen dieser Beschreibung sind die Begriffe "oben", "unten", "horizontal", "vertikal" als Angaben der Ausrichtung zu verstehen, wenn der Kraftfahrzeugscheinwerfer in normaler Benutzungsstellung angeordnet ist, nachdem er in einem im Kraftfahrzeug eingebaut wurde.

Die Erfindung wird nachstehend anhand eines bevorzugten Ausführungsbeispiels, auf das sie jedoch nicht beschränkt sein soll, noch weiter erläutert. In den Zeichnungen zeigt:
Fig. 1 eine Seitenansicht und eine Draufsicht eines Ausgangsmaterials, welches einen ersten, zweiten und dritten Teilbereich aufweist;
Fig. 2 eine Seitenansicht und eine Draufsicht des Ausgangsmaterials nach dem ersten Faltvorgang;
Fig. 3 eine Seitenansicht und eine Draufsicht des Ausgangsmaterials gemäß Fig. 2 mit einem am zweiten Teilbereich angebrachten Steuergerät;
Fig. 4 eine Seitenansicht und eine Draufsicht des Ausgangsmaterials nach dem zweiten Faltvorgang;
Fig. 5 eine zweite Ausführungsform des Ausgangsmaterials, welches einen ersten, zweiten und dritten Teilbereich in einer alternativen Anordnung aufweist; und
Fig. 6 eine dritte Ausführungsform des Ausgangsmaterials, welches einen ersten, zweiten und dritten Teilbereich in einer weiteren alternativen Anordnung aufweist.

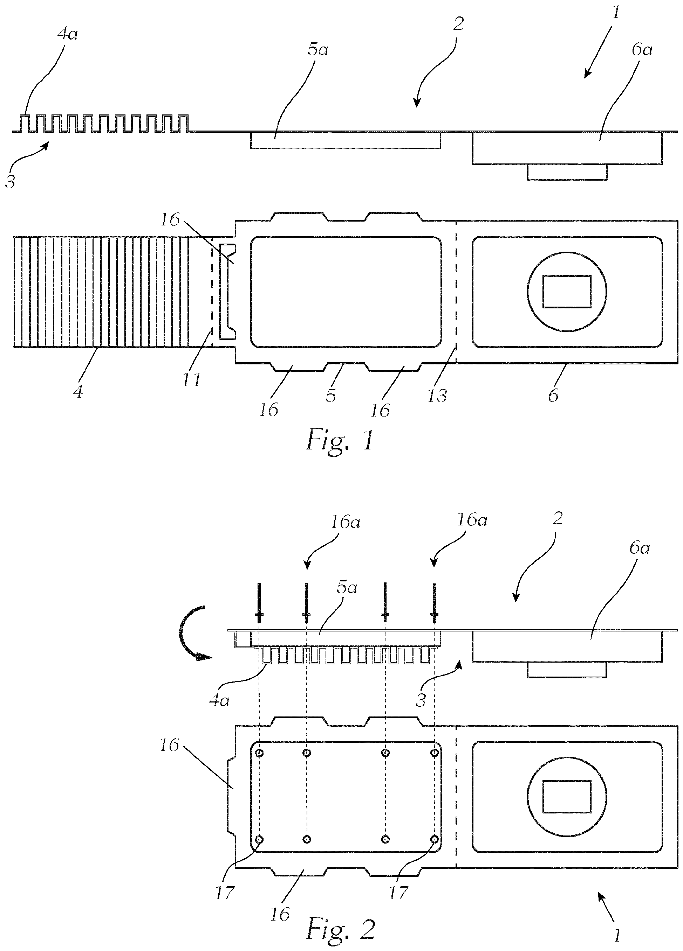

Fig. 1 zeigt ein im Wesentlichen streifenförmiges, vorzugsweise metallisches, Ausgangsmaterial 1, welches eine Oberseite 2 und eine Unterseite 3 aufweist, wobei das Ausgangsmaterial 1 in drei, im gezeigten Ausführungsbeispiel gleich große, aneinander angrenzende Teilbereiche 4, 5, 6 unterteilt ist, welche durch Faltachsen getrennt sind. Der erste Teilbereich 4 grenzt an den zweiten Teilbereich 5 und der zweite Teilbereich 5 grenzt an den dritten Teilbereich 6, sodass der zweite Teilbereich 5 zwischen dem ersten 4 und dem dritten Teilbereich 6 angeordnet ist. Das Ausgangsmaterial 1 wird durch mechanisches Formen und Falten in ein Gehäuse 7, welches ein Steuergerät 8 umschließt, umgeformt. Zu diesem Zweck ist das Ausgangsmaterial 1 bevorzugt ein Metallstreifen, wobei das Metall mechanische Eigenschaften aufweist, welche plastische und bruchfreie Form- und Faltvorgänge zulassen. In dem gezeigten Ausführungsbeispiel besteht das Ausgangmaterial 1 aus einem einzigen Metallstreifen. An einem ersten Teilbereich 4 des Ausgangsmaterials 1 sind Kühlrippen 4a geformt, wobei die Kühlrippen 4a durch mechanisches Formen beispielsweise durch Pressen des ersten Teilbereichs 4 gegen eine entsprechende Kontur geformt werden. An einem zweiten Teilbereich 5 des Ausgangsmaterials 1 ist ein Gehäuseboden 5a geformt. Der zweite Teilberiech 5 entspricht einem Mittelbereich des Ausgangsmaterials 1, wobei das Ausgangsmaterial 1 zwischen dem ersten Teilbereich 4 und dem zweiten Teilbereich 5 eine erste Faltachse 11 aufweist. An einem dritten Teilbereich 6 des Ausgangsmaterials 1 ist ein Gehäusedeckel 6a geformt, wobei das Ausgangsmaterial 1 zwischen dem zweiten Teilbereich 5 und dem dritten Teilbereich 6 eine zweite Faltachse 13 aufweist. Der Gehäuseboden 5a und der Gehäusedeckel 6a werden beispielsweise durch mechanisches Pressen der entsprechenden Teilbereiche gegen entsprechende Konturen geformt.

Fig. 2 zeigt das Ausgangsmaterial 1 nach dem ersten Faltvorgang. Die Unterseite 3 des ersten Teilbereichs 4 des Ausgangsmaterials 1 ist um die erste Faltachse 11 auf die Unterseite 3 des zweiten Teilbereichs 5 des Ausgangsmaterials 1 gefaltet. Im gefalteten Zustand sind der erste Teilbereich 4 und der zweite Teilbereich 5 im Wesentlichen deckungsgleich übereinander orientiert, wobei die Unterseite 3 des ersten Teilbereichs 4 und die Unterseite 3 des zweiten Teilbereichs 5 direkt miteinander in Kontakt sind.

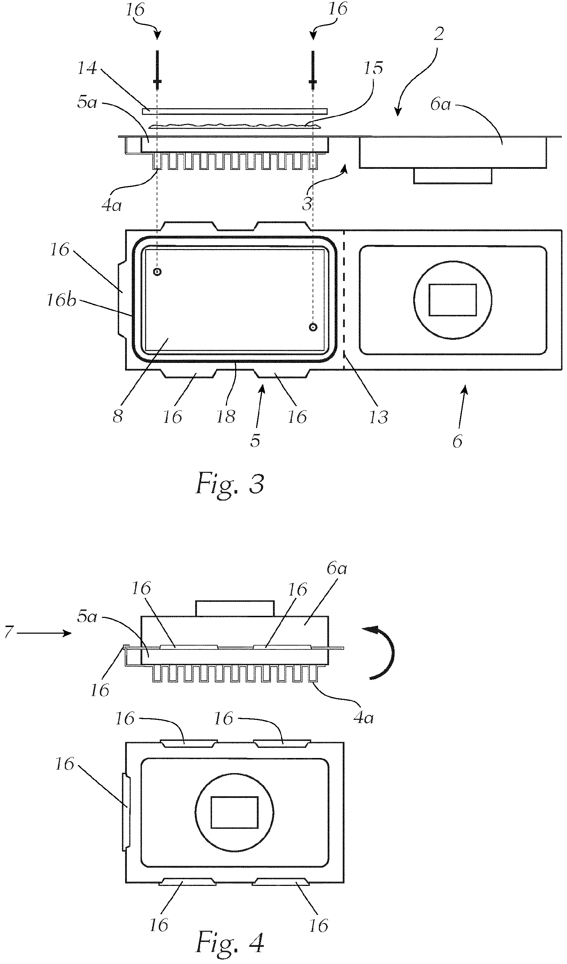

Fig. 3 zeigt das Ausgangsmaterial 1 nach Verfahrensschritt f). Ein Steuergerät 8, welches insbesondere dazu eingerichtet ist, einen Kraftfahrzeugscheinwerfer zu steuern, ist an der Oberseite 2 des zweiten Teilbereichs 5 des Ausgangsmaterials 1 befestigt. Die Befestigung des Steuergeräts 8 an dem zweiten Teilbereich 5 erfolgt beispielsweise mit Nieten und/oder Kleber. Das Steuergerät 8 umfasst eine Leiterplatte 14 mit einer daran angebrachten (nicht gezeigten) elektronischen Schaltung zum Ansteuern des Kraftfahrzeugscheinwerfers. Zwischen der Leiterplatte 14 des Steuergeräts 8 und dem zweiten Teilbereich 5 ist ein Füllmaterial 15 angebracht. Das Füllmaterial 15 ist eine Wärmeleitpaste, insbesondere eine silikonhaltige oder silikonfreie pastöse Wärmeleitpaste.

Fig. 4 zeigt das Ausgangsmaterial 1 nach dem zweiten Faltvorgang. Die Oberseite 2 des dritten Teilbereichs 6 des Ausgangsmaterials 1 ist um die zweite Faltachse 13 auf die Oberseite 2 des zweiten Teilbereichs 5 des Ausgangsmaterials 1 gefaltet. Im gefalteten Zustand sind der zweite Teilbereich 5 und der dritte Teilbereich 6 im Wesentlichen deckungsgleich übereinander orientiert. Der Gehäuseboden 5a und der Gehäusedeckel 6a sind derart ausgebildet, dass im übereinander gefalteten Zustand zwischen dem Gehäuseboden 5a und dem Gehäusedeckel 6a eine das Steuergerät 8 umschließende Gehäusekammer gebildet ist.

Der erste Teilbereich 4 ist an dem zweiten Teilbereich 5 mit einem (in Fig. 2 gezeigten) ersten Fixiermittel 16a fixiert. Ferner ist der zweite Teilbereich 5 an dem dritten Teilbereich 6 mit einem (in Fig. 3 gezeigten) zweiten Fixiermittel 16b fixiert, sodass der erste Teilbereich 4 mit dem zweiten Teilbereich 5 und der zweite Teilbereich 5 mit dem dritten Teilbereich 6 durch das Zusammenwirken der ersten 16a und zweiten Fixiermittel 16b fest miteinander verbunden sind. Das erste 16a und zweite Fixiermittel 16b können gleichartig oder unterschiedlich ausgestaltet sein. Allgemein kann das Fixiermittel 16 beispielsweise als zumindest eine Faltlasche, Nietenverbindung, Schweißverbindung, Rastverbindung oder Klebeverbindung ausgebildet sein. In Fig. 2 ist ersichtlich, dass das erste Fixiermittel 16a als Nietenverbindung ausgebildet ist, wobei acht Bohrungen 17 für die Nieten vorgesehen sind. In Fig. 3 ist ersichtlich, dass das zweite Fixiermittel 16b als Klebeverbindung ausgebildet ist, wobei die Klebeverbindung als geschlossene Klebstoffbahn 18 entlang eines Randbereichs des Gehäusebodens 5a verläuft. Die Klebstoffbahn 18 kann auch stattdessen oder zusätzlich am Gehäusedeckel 6a angebracht sein. Es kann auch ein Fixiermittel 16 den ersten 4, zweiten 5 und dritten Teilbereich 6 aneinander fixeren. Beispielsweise kann durch alle Teilbereiche 4, 5, 6 zumindest eine Bohrung 17 für eine Nietenverbindung vorgesehen sein.

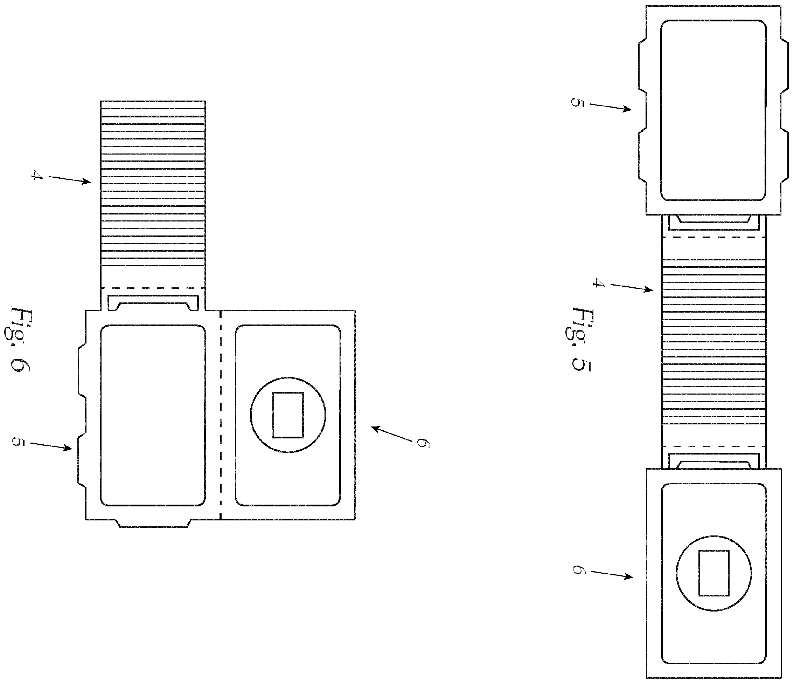

Fig. 5 zeigt eine zweite Ausführungsform, bei welchem die Kühlrippen 4a zwischen dem Gehäuseboden 5a und dem Gehäusedeckel 6a angeordnet sind. Bei dem Falten des Ausgangsmaterials 1, wird die Unterseite 3 des ersten Teilbereichs 4 des Ausgangsmaterials 1 um die erste Faltachse 11 auf die Unterseite 3 des zweiten Teilbereichs 5 des Ausgangsmaterials 1 gefaltet. Mit anderen Worten, wird der Gehäuseboden 5a auf die Kühlrippen 4a gefaltet. In einem zweiten Schritt wird die Unterseite 3 des dritten Teilbereichs 6 des Ausgangsmaterials 1 um die zweite Faltachse 13 auf die Oberseite 2 des zweiten Teilbereichs 5 des Ausgangsmaterials 1 gefaltet. Mit anderen Worten wird der Gehäusedeckel 6a auf die den Kühlrippen 4a abgewandte Seite des Gehäusebodens 5a gefaltet.

Fig. 6 zeigt eine weitere Ausführungsform, bei welchem die drei Teilbereiche 4, 5, 6 des Ausgangsmaterials 1 eine L-förmige Anordnung aufweisen.

### Bezugszeichen

- 1: Ausgangsmaterial
- 2: Oberseite
- 3: Unterseite
- 4: erster Teilbereich
- 4a: Kühlrippen
- 5: zweiter Teilbereich
- 5a: Gehäuseboden
- 6: dritter Teilbereich
- 6a: Gehäusedeckel
- 7: Gehäuse
- 8: Steuergerät
- 11: erste Faltachse
- 13: zweite Faltachse
- 14: Leiterplatte
- 15: Füllmaterial
- 16: Fixiermittel
- 16a: erstes Fixiermittel
- 16b: zweites Fixiermittel
- 17: Bohrung
- 18: Klebstoffbahn

## Patentansprüche

1. Verfahren zur Herstellung eines ein Steuergerät (8) umschließenden Gehäuses (7) durch mechanisches Formen eines Ausgangsmaterials (1), wobei das Steuergerät (8) insbesondere zum Steuern eines Kraftfahrzeugscheinwerfers eingerichtet ist, **gekennzeichnet durch** die folgenden Schritte:
a) Bereitstellen eines im Wesentlichen streifenförmigen, vorzugsweise metallischen, Ausgangsmaterials (1), welches eine Oberseite (2) und eine Unterseite (3) aufweist, wobei das Ausgangsmaterial (1) in zumindest drei aneinander angrenzende Teilbereiche (4, 5, 6) unterteilt ist, welche durch Faltachsen (11, 13) getrennt sind;
b) Formen von Kühlrippen (4a) an einem ersten Teilbereich (4) des Ausgangsmaterials (1);
c) Formen eines Gehäusebodens (5a) an einem zweiten Teilbereich (5) des Ausgangsmaterials (1), welcher vorzugsweise einem Mittelbereich des Ausgangsmaterials (1) entspricht, wobei das Ausgangsmaterial (1) zwischen dem ersten Teilbereich (4) und dem zweiten Teilbereich (5) eine erste Faltachse (11) aufweist;
d) Formen eines Gehäusedeckels (6a) an einem dritten Teilbereich (6) des Ausgangsmaterials (1), wobei das Ausgangsmaterial (1) zwischen dem zweiten Teilbereich (5) und dem dritten Teilbereich (6) eine zweite Faltachse (13) aufweist;
e) Ausführen eines Faltvorgangs, bei welchem die Unterseite (3) des ersten Teilbereichs (4) des Ausgangsmaterials (1) um die erste Faltachse (11) auf die Unterseite (3) des zweiten Teilbereichs (5) des Ausgangsmaterials (1) gefaltet wird, sodass im gefalteten Zustand der erste Teilbereich (4) und der zweite Teilbereich (5) im Wesentlichen deckungsgleich übereinander orientiert sind, wobei die Unterseite (3) des ersten Teilbereichs (4) und die Unterseite (3) des zweiten Teilbereichs (5) direkt, vorzugsweise zumindest abschnittsweise vollflächig, miteinander in Kontakt sind;
f) Anbringen von dem Steuergerät (8), welches insbesondere dazu eingerichtet ist einen Kraftfahrzeugscheinwerfer zu steuern, an der Oberseite (2) des zweiten Teilbereichs (5) des Ausgangsmaterials (1);
g) Ausführen eines Faltvorgangs, bei welchem die Oberseite (2) des dritten Teilbereichs (6) des Ausgangsmaterials (1) um die zweite Faltachse (13) auf die Oberseite (2) des zweiten Teilbereichs (5) des Ausgangsmaterials (1) gefaltet wird, oder Ausführen eines Faltvorgangs, bei welchem die Unterseite (3) des dritten Teilbereichs (6) des Ausgangsmaterials (1) um die zweite Faltachse (13) auf die Oberseite (2) des zweiten Teilbereichs (5) des Ausgangsmaterials (1) gefaltet wird, sodass im gefalteten Zustand der zweite Teilbereich (5) und der dritte Teilbereich (6) im Wesentlichen deckungsgleich übereinander orientiert sind, wobei der in Schritt c) geformte Gehäuseboden (5a) und der in Schritt d) geformte Gehäusedeckel (6a) derart ausgebildet sind, dass im übereinander gefalteten Zustand zwischen dem Gehäuseboden (5a) und dem Gehäusedeckel (6a) eine das Steuergerät (8) umschließende Gehäusekammer gebildet ist;
h) Fixieren des ersten Teilbereichs (4) an dem zweiten Teilbereich (5) und/oder Fixieren des zweiten Teilbereichs (5) an dem dritten Teilbereich (6) mit zumindest einem Fixiermittel (16), sodass der erste Teilbereich (4) mit dem zweiten Teilbereich (5) und/oder der zweite Teilbereich (5) mit dem dritten Teilbereich (6) durch das Zusammenwirken des zumindest einen Fixiermittels (16) miteinander verbunden sind.

2. Verfahren nach Anspruch 1, wobei der erste Teilbereich (4) an den zweiten Teilbereich (5) angrenzt und der zweite Teilbereich (5) an den dritten Teilbereich (6) angrenzt, sodass der zweite Teilbereich (5) zwischen dem ersten (4) und dem dritten Teilbereich (6) angeordnet ist, oder der zweite Teilbereich (5) an den ersten Teilbereich (4) und der erste Teilbereich (4) an den dritten Teilbereich (6) angrenzt, sodass der erste Teilbereich (4) zwischen dem zweiten (5) und dem dritten Teilbereich (6) angeordnet ist.

3. Verfahren nach einem der vorhergehenden Anspruch 1 oder 2, wobei das zumindest eine Fixiermittel (16) als Faltlaschen, Nietenverbindung, Schweißverbindung, Rastverbindung oder Klebeverbindung ausgebildet ist.

4. Verfahren nach einem der vorhergehenden Ansprüche, wobei das zumindest eine Fixiermittel (16) ein erstes (16a) und ein zweites Fixiermittel (16b) umfasst, wobei das erste Fixiermittel (16a) den ersten Teilbereich (4) an dem zweiten Teilbereich (5) fixiert und das zweite Fixiermittel (16b) den zweiten Teilbereich (5) an dem dritten Teilbereich (6) fixiert.

5. Verfahren nach Anspruch 4, wobei das zweite Fixiermittel (16b) als Klebeverbindung ausgebildet ist, die den Gehäuseboden (5a) an dem Gehäusedeckel (6a) fixiert und dazu eingerichtet ist, die Gehäusekammer abzudichten.

6. Verfahren nach einem der vorhergehenden Ansprüche, wobei das Verfahren nach Schritt c) und vor dem Anbringen des Steuergeräts (8) gemäß Schritt f) den folgenden weiteren Schritt umfasst:
- Anbringen eines Füllmaterials (15) zwischen dem Steuergerät (8) und dem zweiten Teilbereich (5), wobei das Füllmaterial (15) eine Wärmeleitpaste, insbesondere eine silikonhaltige oder silikonfreie pastöse Wärmeleitpaste, umfasst.

7. Verfahren nach Anspruch 6, wobei das Steuergerät (8) eine Leiterplatte (14) mit einer daran angebrachten elektronischen Schaltung zum Ansteuern des Kraftfahrzeugscheinwerfers umfasst, wobei das Füllmaterial (15) zwischen der Leiterplatte (14) und dem zweiten Teilbereich (5) angebracht wird.

8. Verfahren nach Anspruch 6 oder 7, wobei das Füllmaterial (15) eine Wärmeleitfähigkeit größer 1 W/mK aufweist.

9. Verfahren nach einem der vorhergehenden Ansprüche, wobei das Ausgangsmaterial (1) einen Metallstreifen umfasst, wobei das Metall mechanische Eigenschaften aufweist, welche plastische und bruchfrei Faltvorgänge gemäß den Verfahrensschritten e) und g) zulassen.

10. Verfahren nach einem der vorhergehenden Ansprüche, wobei das Ausgangmaterial (1) aus einem einzigen Metallstreifen besteht.

11. Steuerungsmodul, umfassend ein Steuergerät (8), welches insbesondere zur Steuerung eines Kraftfahrzeugscheinwerfers eingerichtet ist, und ein das Steuergerät umschließendes Gehäuse (7), **dadurch gekennzeichnet, dass** das Gehäuse (7) durch ein Verfahren nach einem der vorhergehenden Ansprüche hergestellt ist.

12. Kraftfahrzeugscheinwerfer, umfassend ein Steuerungsmodul nach Anspruch 11.

## Claims

1. Method for producing a housing (7) enclosing a control unit (8) by mechanically shaping a starting material (1), the control unit (8) being set up in particular for controlling a motor vehicle headlamp, **characterized by** the following steps:
a) providing a substantially strip-shaped, preferably metallic, starting material (1), which has an upper side (2) and a lower side (3), the starting material (1) being subdivided into at least three adjoining subregions (4, 5, 6), which are separated by folding axes (11, 13);
b) forming cooling fins (4a) on a first sub-region (4) of the starting material (1);
c) forming a housing bottom (5a) at a second partial region (5) of the starting material (1), which preferably corresponds to a central region of the starting material (1), the starting material (1) having a first folding axis (11) between the first partial region (4) and the second partial region (5);
d) forming a housing cover (6a) at a third partial region (6) of the starting material (1), the starting material (1) having a second folding axis (13) between the second partial region (5) and the third partial region (6);
e) carrying out a folding process in which the underside (3) of the first part region (4) of the starting material (1) is folded about the first folding axis (11) onto the underside (3) of the second part region (5) of the starting material (1), so that, in the folded state, the first part region (4) and the second part region (5) are oriented essentially congruently one above the other, the underside (3) of the first part region (4) and the underside (3) of the second part region (5) being in direct contact with one another, preferably at least in sections over the entire surface;
f) attaching the control unit (8), which is set up in particular to control a motor vehicle headlight, to the upper side (2) of the second part region (5) of the starting material (1);
g) carrying out a folding operation in which the upper side (2) of the third part region (6) of the starting material (1) is folded about the second folding axis (13) onto the upper side (2) of the second part region (5) of the starting material (1), or carrying out a folding process in which the underside (3) of the third part region (6) of the starting material (1) is folded about the second folding axis (13) onto the upper side (2) of the second part region (5) of the starting material (1), so that, in the folded state, the second partial region (5) and the third partial region (6) are oriented essentially congruently one above the other, the housing base (5a) formed in step c) and the housing cover (6a) formed in step d) being designed in such a way that, in the state folded one above the other, a housing chamber enclosing the control device (8) is formed between the housing base (5a) and the housing cover (6a);
h) fixing the first part region (4) to the second part region (5) and/or fixing the second part region (5) to the third part region (6) with at least one fixing means (16), so that the first part region (4) is connected to the second part region (5) and/or the second part region (5) is connected to the third part region (6) by the interaction of the at least one fixing means (16).

2. Method according to claim 1, wherein the first sub-region (4) is adjacent to the second subregion (5) and the second sub-region (5) is adjacent to the third sub-region (6), so that the second sub-region (5) is arranged between the first (4) and the third sub-region (6), or the second subregion (5) is adjacent to the first sub-region (4) and the first sub-region (4) is adjacent to the third sub-region (6), so that the first sub-region (4) is arranged between the second (5) and the third sub-region (6).

3. Method according to one of the preceding claims 1 or 2, wherein the at least one fixing means (16) is designed as a folding tab, rivet connection, welded connection, latching connection or adhesive connection.

4. Method according to any one of the preceding claims, wherein the at least one fixing means (16) comprises a first fixing means (16a) and a second fixing means (16b), wherein the first fixing means (16a) fixes the first part region (4) to the second part region (5) and the second fixing means (16b) fixes the second part region (5) to the third part region (6).

5. Method according to claim 4, wherein the second fixing means (16b) is formed as an adhesive joint which fixes the housing bottom (5a) to the housing cover (6a) and is adapted to seal the housing chamber.

6. Method according to any one of the preceding claims, wherein the method comprises the following further step after step c) and before attaching the control unit (8) according to step f):
- Applying a filler material (15) between the control unit (8) and the second sub-region (5), wherein the filler material (15) comprises a thermal paste, in particular a silicone-containing or silicone-free pasty thermal paste.

7. Method according to claim 6, wherein the control unit (8) comprises a printed circuit board (14) with an electronic circuit attached thereto for controlling the motor vehicle headlamp, wherein the filling material (15) is applied between the printed circuit board (14) and the second subregion (5).

8. Method according to claim 6 or 7, wherein the filler material (15) has a thermal conductivity greater than 1 W/mK.

9. Method according to any one of the preceding claims, wherein the starting material (1) comprises a metal strip, said metal having mechanical properties which allow plastic and fracturefree folding operations according to process steps e) and g).

10. Method according to any one of the preceding claims, wherein the starting material (1) comprises a single metal strip.

11. Control module, comprising a control unit (8), which is set up in particular for controlling a motor vehicle headlight, and a housing (7) enclosing the control unit, **characterized in that** the housing (7) is produced by a method according to one of the preceding claims.

12. Motor vehicle headlamp, comprising a control module according to claim 11.

## Revendications

1. Procédé de fabrication d'un boîtier (7) entourant un appareil de commande (8) par moulage mécanique d'un matériau de départ (1), l'appareil de commande (8) étant notamment conçu pour commander un phare de véhicule automobile, **caractérisé par** les étapes suivantes :
a) préparation d'un matériau de départ (1) essentiellement en forme de bande, de préférence métallique, qui présente une face supérieure (2) et une face inférieure (3), le matériau de départ (1) étant divisé en au moins trois zones partielles (4, 5, 6) contiguës, qui sont séparées par des axes de pliage (11, 13) ;
b) former des ailettes de refroidissement (4a) sur une première zone partielle (4) du matériau de départ (1) ;
c) moulage d'un fond de boîtier (5a) sur une deuxième zone partielle (5) du matériau de départ (1), qui correspond de préférence à une zone centrale du matériau de départ (1), le matériau de départ (1) présentant un premier axe de pliage (11) entre la première zone partielle (4) et la deuxième zone partielle (5) ;
d) former un couvercle de boîtier (6a) sur une troisième zone partielle (6) du matériau de départ (1), le matériau de départ (1) présentant un deuxième axe de pliage (13) entre la deuxième zone partielle (5) et la troisième zone partielle (6) ;
e) exécution d'un processus de pliage, au cours duquel la face inférieure (3) de la première zone partielle (4) du matériau de départ (1) est pliée autour du premier axe de pliage (11) sur la face inférieure (3) de la deuxième zone partielle (5) du matériau de départ (1), de sorte qu'à l'état plié, la première zone partielle (4) et la deuxième zone partielle (5) sont orientées l'une au-dessus de l'autre de manière sensiblement congruente, la face inférieure (3) de la première zone partielle (4) et la face inférieure (3) de la deuxième zone partielle (5) étant en contact direct l'une avec l'autre, de préférence sur toute la surface au moins par sections ;
f) appliquer l'appareil de commande (8), qui est notamment conçu pour commander un projecteur de véhicule automobile, sur la face supérieure (2) de la deuxième zone partielle (5) du matériau de départ (1) ;
g) réalisation d'une opération de pliage au cours de laquelle la face supérieure (2) de la troisième zone partielle (6) du matériau de départ (1) est pliée autour du deuxième axe de pliage (13) sur la face supérieure (2) de la deuxième zone partielle (5) du matériau de départ (1), ou effectuer une opération de pliage dans laquelle la face inférieure (3) de la troisième zone partielle (6) du matériau de départ (1) est pliée autour du deuxième axe de pliage (13) sur la face supérieure (2) de la deuxième zone partielle (5) du matériau de départ (1), de sorte qu'à l'état plié, la deuxième zone partielle (5) et la troisième zone partielle (6) sont orientées l'une au-dessus de l'autre sensiblement en coïncidence, le fond de boîtier (5a) formé à l'étape c) et le couvercle de boîtier (6a) formé à l'étape d) étant réalisés de telle sorte qu'à l'état plié l'un sur l'autre, une chambre de boîtier entourant l'appareil de commande (8) est formée entre le fond de boîtier (5a) et le couvercle de boîtier (6a) ;
h) fixer la première zone partielle (4) sur la deuxième zone partielle (5) et/ou fixer la deuxième zone partielle (5) sur la troisième zone partielle (6) avec au moins un moyen de fixation (16), de sorte que la première zone partielle (4) est reliée à la deuxième zone partielle (5) et/ou la deuxième zone partielle (5) est reliée à la troisième zone partielle (6) par l'action conjointe du au moins un moyen de fixation (16).

2. Procédé selon la revendication 1, dans lequel la première sous-zone (4) est adjacente à la deuxième sous-zone (5) et la deuxième sous-zone (5) est adjacente à la troisième sous-zone (6), de sorte que la deuxième sous-zone (5) est située entre la première (4) et la troisième sous-zone (6), ou la deuxième sous-zone (5) est adjacente à la première sous-zone (4) et la première sous-zone (4) est adjacente à la troisième sous-zone (6), de sorte que la première sous-zone (4) est située entre la deuxième (5) et la troisième sous-zone (6).

3. Procédé selon l'une des revendications précédentes 1 ou 2, dans lequel le au moins un moyen de fixation (16) est réalisé sous forme de pattes de pliage, d'assemblage par rivets, d'assemblage par soudage, d'assemblage par encliquetage ou d'assemblage par collage.

4. Procédé selon l'une quelconque des revendications précédentes, dans lequel ledit au moins un moyen de fixation (16) comprend un premier (16a) et un deuxième moyen de fixation (16b), ledit premier moyen de fixation (16a) fixant ladite première portion (4) à ladite deuxième portion (5) et ledit deuxième moyen de fixation (16b) fixant ladite deuxième portion (5) à ladite troisième portion (6).

5. Procédé selon la revendication 4, dans lequel le deuxième moyen de fixation (16b) est réalisé sous la forme d'un assemblage par collage qui fixe le fond du boîtier (5a) au couvercle du boîtier (6a) et qui est adapté pour rendre étanche la chambre du boîtier.

6. Procédé selon l'une quelconque des revendications précédentes, dans lequel le procédé comprend, après l'étape c) et avant la mise en place du dispositif de commande (8) selon l'étape f), l'étape supplémentaire suivante :
- Application d'un matériau de remplissage (15) entre le dispositif de commande (8) et la deuxième partie (5), le matériau de remplissage (15) comprenant une pâte thermiquement conductrice, notamment une pâte thermiquement conductrice pâteuse contenant ou non du silicone.

7. Procédé selon la revendication 6, dans lequel l'appareil de commande (8) comprend une carte de circuit imprimé (14) sur laquelle est monté un circuit électronique pour commander le projecteur du véhicule automobile, le matériau de remplissage (15) étant appliqué entre la carte de circuit imprimé (14) et la deuxième zone partielle (5).

8. Procédé selon la revendication 6 ou 7, dans lequel le matériau de remplissage (15) présente une conductivité thermique supérieure à 1 W/mK.

9. Procédé selon l'une quelconque des revendications précédentes, dans lequel le matériau de base (1) comprend une bande métallique, ledit métal présentant des propriétés mécaniques permettant des opérations de pliage plastique et sans rupture selon les étapes e) et g) du procédé.

10. Procédé selon l'une quelconque des revendications précédentes, dans lequel le matériau de départ (1) est constitué d'une seule bande métallique.

11. Module de commande comprenant un boîtier de commande (8) agencé notamment pour commander un projecteur de véhicule automobile, et un boîtier (7) entourant le boîtier de commande, **caractérisé en ce que** le boîtier (7) est réalisé par un procédé selon l'une quelconque des revendications précédentes.

12. Projecteur de véhicule automobile comprenant un module de commande selon la revendication 11.
